Europäisches Patentamt

European Patent Office

Office européen des brevets

(19)

(11) Veröffentlichungsnummer: **0 153 468**

**A2**

(12) # EUROPÄISCHE PATENTANMELDUNG

(21) Anmeldenummer: 84115190.5

(22) Anmeldetag: 12.12.84

(51) Int. Cl.⁴: **H 01 L 21/268**
**H 01 L 21/20**

(30) Priorität: 27.02.84 DE 3407089

(43) Veröffentlichungstag der Anmeldung:
04.09.85 Patentblatt 85/36

(84) Benannte Vertragsstaaten:
DE FR GB NL

(71) Anmelder: Siemens Aktiengesellschaft
Berlin und München Wittelsbacherplatz 2
D-8000 München 2(DE)

(72) Erfinder: Lutsch, Adolf G.K., Professor, Dr.
Johannesstr. 6 Brighton
2195 Johannesburg 236(ZA)

(72) Erfinder: Krimmel, Eberhard. F., Prof. Dr.
Mendelssohnstrasse 7
D-8023 Pullach(DE)

(54) Verfahren und Vorrichtung zur lichtinduzierten, fotolytischen Abscheidung.

(57) Mit Hilfe eines Verfahrens zur lichtinduzierten, fotolytischen Abscheidung werden Halbleiter-Bauelemente hergestellt, die mehrere aufeinanderliegende, insbesondere periodisch abwechselnde Schichten (Hyperfeinstruktur-Elemente) besitzen und/oder Dotierungsmuster aufweisen, die gleichzeitig mit der Abscheidung der Schichten und/oder mit wahlfreien Dotierungsgradienten hergestellt sein können. Insbesondere eignet sich das Verfahren auch zur gleichzeitigen lateral nebeneinanderliegenden Abscheidung von Schichten oder lateral nebeneinander verschiedener Dotierung in Abscheidung befindlicher Schichten. Im Zusammenhanbg mit Dotierung werden mit Hilfe der Erfindung die von Implantationen her bekannten Strahlenschäden vermieden.

FIG 1

EP 0 153 468 A2

SIEMENS AKTIENGESELLSCHAFT
Berlin und München

Unser Zeichen 0153468
VPA 84 P 8007 E

Verfahren und Vorrichtung zur lichtinduzierten, fotolytischen Abscheidung.

Die vorliegende Erfindung bezieht sich auf ein Verfahren
nach dem Oberbegriff des Anspruchs 1 sowie eine Vorrichtung zur Durchführung des Verfahrens nach Anspruch 7.

Es ist bekannt, dünne Schichten oder Schichtfolgen aus gleichem Material oder aus verschiedenen Materialien auf einem
Substrat auf gleichem oder weiterem Material abzuscheiden.
Hierzu am weitesten verbreitet ist das thermische Aufdampffen. Üblich ist aber auch das Abscheiden nach Plasma-Verfahren und die Molekularstrahl-Epitaxie unter Verwendung verschiedener Quellen für die Materialien oder einer Quelle mit
einer durch die herzustellenden Schichten vorgegebenen Materialzusammensetzung. An sich unproblematisch ist das Herstellen derartiger, insbesondere sehr dünner, Schichten, die
weitgehend homogen verteilt die jeweilige Oberfläche bedekken, auf der eine solche jeweilige Schicht abgeschieden ist.
Erhebliche Schwierigkeiten ergeben sich aber dann, wenn vorgegebene Konzentrationsverhältnisse und/oder Konzentrationsgradienten verschiedener Komponenten der Schicht verlangt
werden, und zwar dies in Richtung der Oberflächennormalen
und/oder in beliebiger lateraler Ausdehnung der betreffenden
Schicht.

Aufgabe der vorliegenden Erfindung ist es, ein einfaches und
besonders sicheres Verfahren anzugeben, mit dessen Hilfe man
dotierte oder nichtdotierte Schichten abscheiden kann und/-
oder ein Substrat und/oder eine abgeschiedene Schicht mit
einer Dotierung versehen kann, wobei die abgeschiedene Schicht
und/oder die Dotierung vorgegebene Werte der Konzentration

Bts 1 Bla / 14.2.1984

84 P 8007 E **0153468**

des Abscheidungsmaterials und/oder der Dotierung in Normalenrichtung und/oder in beliebig vorgegebenen lateralen Richtungen aufweist. Eingeschlossen ist dabei der Konzentrationswert "O", z.B. eine mit lateraler Struktur versehene abgeschiedene Schicht und/oder eine Schicht mit in Normalenrichtung und/oder lateraler Richtung aneinandergrenzenden dotierten und undotierten Schichtbereichen.

Diese Aufgabe wird mit einem Verfahren nach dem Patentanspruch 1 erfindungsgemäß gelöst. Weitere Ausgestaltungen und Weiterbildungen der Erfindung gehen aus den Unteransprüchen hervor.

Bei dem erfindungsgemäßen Verfahren wird von dem an sich bekannten Prinzip der fotolytischen, gegebenenfalls auch lichtinduzierten, katalytischen Abscheidung Gebrauch gemacht. Dieses Prinzip besteht für die Aufgabe der Abscheidung einer Schicht darin, mit dem Substrat, auf dessen Oberfläche die Schicht abzuscheiden ist, zur jeweiligen Abscheidung vorgesehenes Material, bevorzugt gasförmig vorliegendes Material, in Kontakt zu bringen und dabei auf dieses Material und/oder die Obefläche des Substrats entsprechend ausgewähltes Licht einwirken zu lassen. Diese Lichteinstrahlung führt zu einem fotolytischen Prozeß, der das Aufwachsen von Material auf einer Oberfläche bewirkt und/oder zu Dotierungsvorgängen führt. Dort, wo dieses entsprechende Licht hingelangt, geht dieser Prozeß mit Abscheidung und/oder Dotierung vor sich. Verwendet man nämlich eine Maske, die eine laterale Strukturierung der Intensität des eingestrahlten Lichtes auf der betreffenden Oberfläche bewirkt, so ergibt sich eine entsprechend örtlich vorgebbare Abscheidung und/oder Dotierung. Da während des zeitlichen Ablaufes der Abscheidung die eingestrahlte Lichtintensität durch entsprechende, an sich bekannte Maßnahmen gesteuert bzw. moduliert werden kann, läßt sich damit

84 P 80Q153468

der zeitliche Aufwachsvorgang bzw. Dotierungsablauf
entsprechend variieren. Die beiden Fälle führen somit zu
lateralen bzw. zu in Normalenrichtung auftretenden Konzentrationsunterschieden der Abscheidung und/oder Dotierung.

Mit den erfindungsgemäßen Maßnahmen des Patentanspruchs 1
läßt sich aber eine ganz besondere Art der Abscheidung oder
Dotierung durchführen, die als integrierte Abscheidung bzw.
als integrierte Dotierung bezeichnet ist. Es handelt sich
dabei darum, daß wenigstens zwei verschiedene Materialien
gleichzeitig und/oder in unmittelbarer zeitlicher Folge aufeinander als Schicht abgeschieden werden und/oder entsprechend unterschiedliche Dotierungen bewirken. Dazu gehört,
eine einzelne Schicht abzuscheiden und gleichzeitig während
dieser Abscheidung homogen oder insbesondere auch inhomogen
verteilt eine oder mehrere verschiedene Dotierungen gleichzeitig mit der Abscheidung zu erzeugen. Ebenfalls gehört
dazu, zwei oder mehrere Schichten aufeinander abzuscheiden,
und zwar insbesondere periodisch abwechselnde Folgen von
vorgegebenen Schichten zu erzeugen. Damit können z.B. Halbleiter-Hyperstrukturen und/oder -Bandmodellierungen in einfacher Weise erzeugt werden. Es kann dabei zusätzlich vorgesehen sein, eine oder mehrere Dotierungen der Schichten
während ihrer Abscheidung zu bewirken. Auch gehört zu dem
Begriff der integrierten Abscheidung und/oder Dotierung die
Arbeitsweise, zwei oder mehrere, voneinander verschiedene
Materialien lateral nebeneinander auf einer Oberfläche abzuscheiden bzw. in einem (zu dotierenden) Schichtbereich lateral nebeneinander zu bewirken.

Das der Erfindung zugrundeliegende Prinzip besteht nicht nur
darin, dafür Sorge zu tragen, daß die jeweiligen zur Abscheidung und/oder Dotierung erforderlichen Materialien - vorzugsweise gasförmig - in Kontakt mit einer betreffenden Oberfläche vorliegen, sondern daß wenigstens zwei frequenzverschiedene Strahlungen eingestrahlt werden. Dabei ist die Frequenz der einen Strahlung auf die Reaktionscharakteristik des einen vorliegenden (abzuscheidenden bzw. dotierenden) Materials abgestimmt gewählt. Eine zweite Strahlung ist frequenzmäßig so ausgewählt, daß sie charakteristisch auf das weitere bzw. ein jeweiliges weiteres Material einwirkt, das zur Abscheidung bzw. zur Dotierung bestimmt ist und in Kontakt mit der Oberfläche vorliegt. Optimale Reaktionswirkung bei einem fotolytischen Prozeß liegt nämlich dann vor, wenn man die Frequenz der betreffenden Strahlung auf die diesbezügliche vorliegende spektrale Empfindlichkeit des jeweiligen Materials abgestimmt auswählt. Solche Zusammenhänge sind an sich prinzipiell bekannt. Der einschlägige Fachmann ist in der Lage, sich für die gegebene erfindungsgemäße Lehre geeignete Paarungen von Material und Frequenz zu verwendender Strahlung auszuwählen.

Der voranstehend angewendete Begriff "licht" im Zusammenhang mit "lichtinduziert oder fotolytisch" ist nicht als beschränkt auf von Menschen sichtbares Licht zu verstehen. Vielmehr erstreckt sich der für dieses "licht" in Frage kommende Frequenzbereich über einen vom infraroten bis zum ultravioletten reichenden Frequenzbereich, der für solche foto-chemischen Vorgänge in Frage kommt.

Durch im Prozeßprogramm für die Abscheidung und/oder Dotierung entsprechende zeitliche Steuerung der Intensitäten wenigstens zweier frequenz-verschiedener Strahlungen, die passend zu dem charakteristischen chemischen Verhalten des betreffenden abzuscheidenden und/oder dotierenden Materials ausgewählt sind, läßt sich in Normalenrichtung ein vorgebba-

84 P 8003E53468

rer Verlauf der Abscheidung und/oder Dotierung erzwingen.
Z.B. läßt sich damit durch entsprechend raschen Frequenzwechsel der Strahlung bzw. entsprechende abwechselnde Intensitätstaktung zweier frequenz-verschiedener Strahlungen
eine exakt definierte Schichtenfolge und/oder Dotierungsfolge erzeugen, die ohne weiteres die jeweils geringen
Schichtdicken hat, die für beispielsweise eine Hyperstruktur erforderlich sind. Bisher hat man versucht, mit Hilfe
der Molekularstrahl-Epitaxie solche Schichtfolgen herzustellen, wobei dies beträchtlich aufwendig ist. In einfacherer Weise derartige, schon lange begehrte Hyperstrukturen
erzeugen zu können, wird zu wesentlichen neuen Fortschritten in der Halbleiter-Anwendung führen.

Mit anderen Worten, das erfindungsgemäße Verfahren löst das
Problem des exakten Einstellens der Konzentrationsverhältnisse der Komponenten sowohl für Änderungen in Oberflächennormalenrichtung wie auch in lateraler Richtung. Dies durchführen zu können ist z.B. wichtig für Halbleiterstrukturen.
Mit der Erfindung ist eine Abscheidung mehrkomponentiger
Systeme möglich. Die erfindungsgemäße Abscheidung eines
Mehrkomponentensystems erfolgt bevorzugt aus der Gasphase.
Laterale Strukturen werden insbesondere unter Anwendung
einer lichtoptischen Projektionsmaske erreicht. Abscheidung
und/oder Dotierung aus flüssiger Phase der entsprechenden
Materialkomponenten ist ebenfalls vorteilhaft anwendbar und
auch Abscheidung und/oder Dotierung aus fester Phase der Komponenten ist möglich, wobei dies häufig bei einer gasförmigen Zwischenphase erfolgen wird.

Die abzuscheidenden Stoffe bzw. Komponenten werden als Bestandteile gasförmiger Molekülarten eingesetzt, die die notwendigerweise energetisch stark unterschiedlichen optischen
Übergänge haben. Zum Beispiel wird ein Zweikomponentensystem mit Licht der beiden zugehörigen Resonanzfrequenzen
bestrahlt und es zerfallen dabei die beiden Molekülarten
mit Prozeßraten, die den jeweiligen Lichtintensitäten entsprechen. Bei Einstrahlung von Licht aus zwei unabhängigen mmonochromatischen Quellen, z.B. Laser-Einrichtungen,
kann somit praktisch jedes gewünschte Materialkomponentenverhältnis eingestellt werden. Bei dabei zeitlicher Variation der Intensitäten lassen sich sogar solche Verhältnisse
mit entsprechenden Gradienten bzw. Verhältnisvariationen
präzise einstellen.

Der fotolytische Prozeß kann im Rahmen der Erfindung auch
eine katalytische Komponente haben, d.h. es können auch frequenzselektive Katalysevorgänge beteiligt sein.

Voranstehend sind bereits eine Anzahl besonderer Vorteile
der Erfindung angegeben. Mit der Erfindung kann insbesondere ein verunreinigender Einbau solcher Substanzen vermieden werden, die sich zwangsläufig im in Betracht kommenden
Gasraum und/oder an dessen Innenwänden befinden, nämlich
weil das erfindungsgemäße Verfahren bei niedrigen Temperaturen bzw. ohne allgemeine Erhitzung abläuft. Insbesondere
ist es bei der Erfindung günstig, die Ausgangsmolekülart der
in Frage kommenden, lichtinduziert zu beeinflussenden Materialien bzw. Komponenten so zu wählen, daß ihre jeweiligen
Frequenzbereiche optimaler Reaktionsempfindlichkeit weit voneinander getrennt sind.

Auf die Erzeugung lateral strukturierter Schichten ist bereits oben hingewiesen worden. Mit der Erfindung ist dies
ohne aufwendige fotolithografische Prozesse möglich. Da
aber die Intensitäten der Quellen für die in Frage kommenden
Strahlungen elektrisch bzw. elektrooptisch mit hoher Zeitauflösung gesteuert werden können, lassen sich mit der Er-

84 P 8 0 0 1 5 3 4 6 8

findung Ergebnisse erzielen, die weit über das mit der Fotolithografie erreichbare hinausgehen.

Die Erfindung ist insbesondere für die ganze Halbleitertechnik von großer Bedeutung. Anwendung findet die Erfindung aber auch im ganzen technologischen Bereich mehrkomponentiger Metallschichten.

Weitere Erläuterungen der Erfindung gehen aus der nachfolgenden, zu den Figuren gegebenen Beschreibung hervor.

Fig.1  zeigt eine Vorrichtung zur Durchführung des Verfahrens und

Fig.2 zeigt eine Prinzipdarstellung für erfindungsgemäß abgeschiedene Schichten mit erfindungsgemäß erzeugten
      Dotierungen.

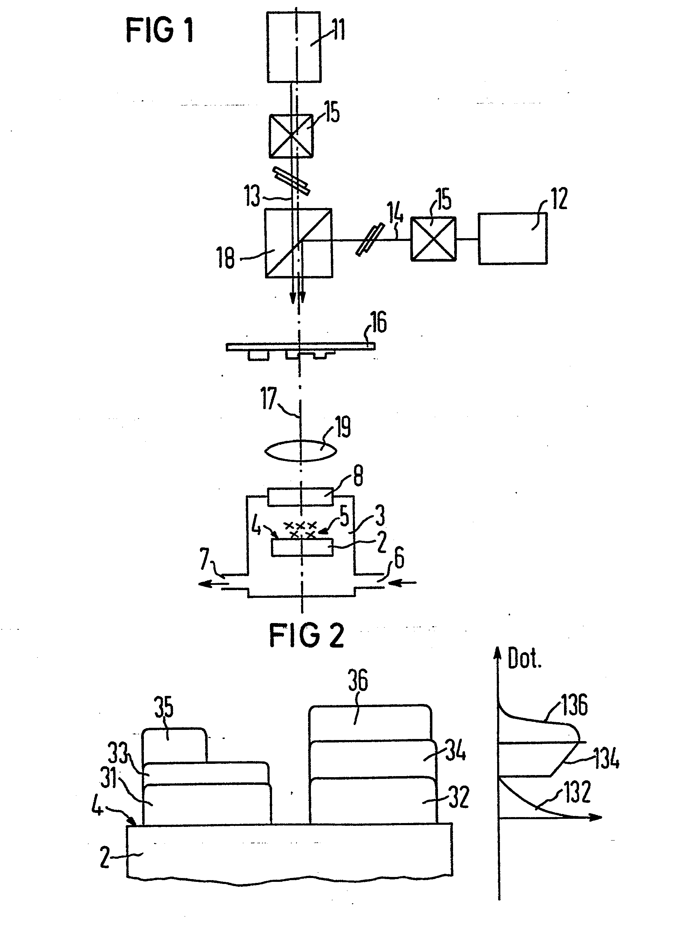

Fig.1 zeigt eine Vorrichtung zur Durchführung eines erfindungsgemäßen Verfahrens. Mit 2 ist ein Substrat aus z.B.
Halbleitermaterial bezeichnet, das sich in einem Reaktionsrezipienten 3 befindet. Im Innern dieses Reaktionsrezipienten 3 und insbesondere oberhalb der Oberfläche 4 des Substrats 2 befinden sich in beispielsweise gasförmigem Zustand
Moleküle der verschiedenen zur Abscheidung und/oder Dotierung vorgesehenen Materialien. Die Kreuze 5 deuten auf dieses Gas hin. Mit 6 und 7 sind ein Gaseinlaß und ein Gasauslaß des Reaktionsrezipienten 3 bezeichnet. Der Oberfläche 4 des Substrats 2 gegenüberliegend enthält die Wand des
Reaktionsrezipienten 3 ein Fenster 8, durch das die zur Durchführung des erfindungsgemäßen Verfahrens erforderlichen Strahlungen möglichst absorptionsfrei hindurchtreten können.

Mit 11 und 12 sind je eine Quelle, insbesondere ein Laser, für die Erzeugung von zwei frequenz-verschiedenen Strahlungen bezeichnet. In dem jeweiligen Strahlengang 13 und 14 der Laser 11 und 12 befinden sich je ein Steuerelement 15 für die Intensitätssteuerung. Z.B. können dies Pockels-Zellen sein.

Beispielsweise ist in der Fig.1 vorgesehen, daß eine Struktur auf der Oberfläche 4 des Substrats 2 erzeugt wird, die - abgesehen von in Normalenrichtung der Oberfläche 4 vorliegenden Gradienten - in lateraler Richtung eine vorgegebene Form hat. Zur Realisierung dieser lateralen Ausbildung der Struktur befindet sich im Strahlengang 17 eine Maske 16 mit strahlungsdurchlässigen und -undurchlässigen Flächenanteilen. Zur weiteren Modulierung der Lichtstrahlintensität können solche Masken auch teildurchlässige Bereiche enthalten. Diese Maske 16 entspricht einer solchen Maske, die für Fotolithografie verwendet wird.

Mittels eines die Strahlungen 13 und 14 vereinigenden optischen Elements 18, das eine zum Teil reflektierende und zum Teil durchlässige Fläche besitzt, sind diese beiden Strahlungen 13 und 14 zur Strahlung 17 vereinigt, die die erwähnte Maske 16 trifft. Entsprechend der optischen Wiedergabe eines Diapositivs erfolgt hier eine Abbildung der Maske selbst auf der Oberfläche 4 des Substrats 2, und zwar mit Hilfe eines Objektivs 19. Weitere Erläuterungen zu Einzelheiten der Strahlengänge sind deshalb nicht erforderlich, weil diese aus der Technik der optischen Abbildungen für den einschlägigen Fachmann hinlänglich bekannt sind.

Wie bereits ausgeführt, wird durch die Maske 16 eine auf der Oberfläche 4 zu erzeugende laterale Struktur in Form eines in lateralen Richtungen ausgebildeten Belichtungsprofils realisiert. Diese flächenmäßig mit unterschiedlicher Intensität erfolgende Belichtung einzelner Flächenbereiche der
Oberfläche 4, d.h. genaugenommen das Vorhandensein einer
entsprechenden Intensitätsverteilung im unmittelbar an die
Oberfläche 4 angrenzenden Raumbereich des Reaktionsrezipienten 3 und der in diesem Raumbereich befindlichen Materialien
5, bewirkt dort den fotolytischen Prozeß. Ist z.B. die Abscheidung einer Schicht auf die Oberfläche 4 vorgesehen, erfolgt aufgrund frequenzmäßiger Abstimmung der Strahlung der
(beispielsweise) Quelle 11, d.h. der Strahlung 13, die in der
Strahlung 17 enthalten ist, dort eine fotolytische Reaktion
mit dem Ergebnis einer Abscheidung auf der Oberfläche 4.
Diese Abscheidung erfolgt jedoch nur an den Stellen, an denen
tatsächlich aufgrund entsprechender Durchlässigkeit bzw. aufgrund der Abbildung der Maske im Bereich der Oberfläche 4
Lichtintensität der Quelle 11 vorhanden ist. An dunklen Stellen des auf der Oberfläche 4 erzeugten Bildes der Maske 16
erfolgt mangels fotolytischen Prozesses praktisch keine Abscheidung.

Die zweite Quelle 12, deren Strahlung 14 sich frequenzmäßig
von der Strahlung 13 unterscheidet und deren Strahlung 14
auf eine zweite Komponente abgestimmt ist, die sich im Gasvolumen 5 befindet, bewirkt - je nach zur Erfindung vorgegebener Aufgabe - die Abscheidung einer weiteren Schicht oder
einen Dotierungsprozeß. Bei vorgesehenem Dotierungsprozeß,
der z.B. gleichzeitig mit dem aufgrund der Strahlung 13 erfolgendem Aufwachsen einer Schicht auf der Oberfläche 4 ablaufen
soll, wird die Strahlung 14 gleichzeitig mit der Strahlung
13 eingestrahlt. Dabei kann z.B. mit dem im Strahlengang 14
befindlichen Element 15 die Intensität der Strahlung 14 gesteuert werden, so daß ein in Normalenrichtung der aufwachsenden Schicht vorgebbarer Gradient der Dotierung vorliegt.

Mit Hilfe der Strahlung 14 der zweiten Quelle 12 kann auch

84 P 8 0075 E
0153468

das Abscheiden einer weiteren Schicht vorgesehen sein, z.B.
auf einer vorangehend unter Mitwirkung der Strahlung 13 abgeschiedenen Schicht. Das jeweilige Element 15 in den Strahlengängen 13 und 14 wird dann so betrieben, daß nur jeweils
eine der beiden Strahlungen 13 und 14 zur Oberfläche 4 gelangt und damit die jeweilige auf Fotolyse beruhende Abscheidung auf der Oberfläche 4 bewirkt. Durch laufend abwechselndes
Steuern der Intensitäten der Strahlungen 13 und 14 kann eine
erwähnte periodische Struktur erzeugt werden.

Alternativ kann z.B. mit Hilfe der Strahlung 13 unter Weglassung der Maske 16 eine gleichmäßige Schicht auf der Oberfläche 4 erzeugt werden. Nachfolgend kann bei eingefügter Maske
16 mit Hilfe der Strahlung 14 eine in lateraler Richtung strukturierte Dotierung dieser zuvor abgeschiedenen Schicht durchgeführt werden.

Beim Arbeiten mit einer Maske wird im Regelfall vorgesehen
sein, daß nur ein einziger gemeinsamer Strahlengang aller die
Oberfläche 4 treffenden Strahlungen vorliegt. Arbeitet man
ohne Maske, z.B. um Mehrfachschicht-Strukturen (ohne laterale Strukturierung) und insbesondere um periodische Schichtfolgen zu erzeugen, können die Strahlungen zweier verschiedener Strahlungsquellen auch in (voneinander verschiedenen)
schrägen Richtungen in den an die Oberfläche 4 unmittelbar
angrenzenden Raumbereich des Rezipienten 3 eingestrahlt werden. Auch in diesem Fall wird das zeitlich aufeinanderfolgende Abscheiden verschiedener Schichten durch entsprechende
zeitliche Steuerung der zu verwendenden Strahlungen bewirkt.

Für den Fachmann gehen aus der vorangehenden Beschreibung
weitere, im Rahmen der der Erfindung liegende Variationsmöglichkeiten von Abscheidungen und/oder Dotierungen hervor, und
zwar indem zeitweise mit oder ohne Maske gearbeitet wird und/ oder indem entsprechend zeitgleich oder entsprechend zeitlich nacheinander die verschiedenen zu verwendenden, frequenz-verschiedenen Strahlungen gesteuert werden.

Analog voranstehend beschriebener Arbeitsweisen können auch
Strahlungen von mehr als zwei Quellen gleichzeitig und/oder
in zeitlicher Folge nacheinander mit entsprechenden Abscheidungsvorgängen und/oder Dotierungsprozessen durchgeführt werden.

Fig.2 zeigt eine Schemadarstellung für Anwendungsvarianten
der Erfindung und dazu eine Seitenansicht eines Schichtaufbaues auf einem Substrat 2 und auf der rechten Seite ein Diagramm mit Dotierungsverläufen.

Auf der Oberfläche 4 sind lateral nebeneinander zwei Schichten 31 und 32 nach einem erfindungsgemäßen Verfahren abgeschieden, indem man lediglich auf diejenigen Oberflächenbereiche der Oberfläche 4 des Substrats 2 die den fotolytischen
Prozeß induzierende Strahlung hat auftreffen lassen, die dann
von den aufgewachsenen Schichten 31 und 32 bedeckt worden sind.
Diese beiden Schichten 31 und 32 konnten der Erfindung entsprechend gleichzeitig zum Aufwachsen gebracht werden.

Mit 33 und 34 sind zwei weitere lateral nebeneinander angeordnete Schichten bezeichnet, wobei die Schicht 33 dünner als
die Schicht 34 ist. Obwohl beide Schichten über den gleichen
Zeitraum hinweg aufgewachsen sind, ist die Schichte 33 dünner
als die Schicht 34, weil im Bereich der Schicht 33 insgesamt
geringere Lichtenergie für den Vorgang der Fotolyse eingestrahlt worden ist, als dies für den Bereich der Schicht 34
durchgeführt worden ist. Mit 35 und 36 sind weitere aufgewachsene Schichten bezeichnet. Die Schicht 35 ist - wie dargestellt - lateral weniger weit ausgedehnt als die Schichten 31 und 33. Dies wird durch entsprechende Änderung der
zur Fig.1 beschriebenen Maske 16 bewirkt.

Für die Schichten 32, 34 und 36 sind rechts neben im dargestellten Schichtaufbau in einem Diagramm mögliche (beispielsweise) Dotierungsverläufe aufgetragen, die mit der Erfindung
ohne Schwierigkeiten erreicht werden können. Während des Aufwachsens der Schicht 32 wurde derjenige Strahlungsanteil, der
für den fotolytischen Prozeß der Dotierung bestimmend ist, im
Lauf der Zeit verringert, so daß sich in Richtung der Dicke
der Schicht 32 ein ständiges Abnehmen der Dotierung entsprechend dem Kurvenzug 132 ergeben hat. Während des Aufwachsens
der Schicht 34 wurde derartige gesteuerte Strahlungsintensität angewendet, so daß sich während des Aufwachsens der Schicht
34 ein Dotierungsverlauf 134 ergeben hat. Mit 136 ist auf
einen frei wählbaren Dotierungsverlauf für die Schicht 36 hingewiesen. Dabei können z.B. die 134 und 136 entsprechenden
Dotierungen entgegengesetzten Leitungstyp haben. Entsprechende
Beziehung kann auch zur Dotierung 132 gegeben sein. Wie ersichtlich, kann mit der Erfindung eine sehr abrupte Dotierungsänderung in einfacher Weise, nämlich durch Wechsel der Frequenz
der die Fotolyse steuernden Strahlung, bewirkt werden. Der
Vollständigkeit halber sei darauf hingewiesen, daß der in der
Fig.2 für die Grenzfläche zwischen den Schichten 34 und 36 angegebene Dotierungsübergang auch innerhalb der Schicht 34 oder
der Schicht 36 liegen kann, d.h. auch während des Aufwachsens
einer einheitlichen Schicht kann durch entsprechenden Wechsel
der eingestrahlten Strahlung der Übergang von einer Dotierung
zu einer anderen Dotierung bewirkt sein. Die für die einzelnen Abscheidungen und/oder für die einzelnen Dotierungen erforderlichen Materialien bzw. Stoffe können sich z.B. auch
von Anfang an in dem Raum des Reaktionsrezipienten 3 befunden
haben und befinden, da mit der extern auszuführenden Auswahl
der Strahlung selektiv der jeweilige fotolytische Abscheidungsprozeß und/oder Dotierungsvorgang wahlfrei ausgewählt und
gesteuert werden kann.

Beispiele für die Anwendung der Erfindung sind die Herstellung von CMOS-Halbleiterbauelemente, von Leistungs-Halbleiterbauelementen, von Halbleiterbauelementen auf der Basis
der SOS-Technologie und dergleichen. Mit der Erfindung können bei CMOS-Elementen in besonders einfacher Weise die dort
vorgesehenen Wannen mit einem besonders hoch dotiertem Boden
versehen werden. Bisher wurde versucht, dieses Ziel durch
Implantations-Dotierung zu erreichen, wobei jedoch einerseits eine große Halbwertsbreite nicht zu vermeiden war und
andererseits große Strahlungsschäden im darüberliegenden Halbleitermaterial der Wanne in Kauf zu nehmen waren. Bei Leistungs-Halbleiterbauelementen, wie z.B. Mehrschicht-Thyristoren, eignet sich die Erfindung dazu, in besonders einfacher
Weise innere, tiefliegende Schichten hoch zu dotieren. Im
Rahmen der SOS-Technologie (Silicon on Saphire, wobei "Saphir"
schlechthin für Isolatorkörper, wie z.B. auch Quarz steht)
läßt sich mit der Erfindung eine nachträglich durchzuführende,
hohe Dotierung an der Grenzfläche zwischen dem Isolator-Substratkörper, aus z.B. geschmolzenem Quarz, und der darauf aufgewachsenen Halbleiterschicht bewirken. Eine solche hohe Dotierung dient dazu, Aufladungen an der Grenzfläche zwischen Isolator und aufgewachsener Halbleiterschicht zu vermeiden. Vorrichtungen, die mit dieser Technologie günstig herzustellen
sind, sind planare Halbleiter Bildschirme.

84 P 8007 E
0153468

Patentansprüche:

1. Verfahren zur lichtinduzierten, fotolytischen und gegebenenfalls katalytischen Abscheidung von Schichten auf und/
oder Dotierung von Substraten und/oder bereits aufgewachsenen Schichten, wobei Abscheidungs- und/oder Dotierungsmaterialien flüssig oder gasförmig mit der Oberfläche des Substrats oder einer jeweiligen bereits aufgewachsenen Schicht
in Berührung stehen, und wobei für diese Fotolyse zu verwendende Strahlung auf diese Oberfläche gerichtet ist,
g e k e n n z e i c h n e t   dadurch,
- daß zur steuerbar wahlweisen integrierten Abscheidung oder
  Dotierung mit wenigstens zwei verschiedenen Materialien
  (5)
- wenigstens zwei frequenz-verschiedene Strahlungen (14, 14)
  verwendet werden,
- deren jeweilige Intensitäten dem Prozeßprogramm der vorgegebenen integrierten Abscheidung und/oder Dotierung entsprechend jede für sich gesteuert (15) werden können,
- und daß die verschiedenen Materialien während des Ablaufs
  des Prozeßprogramms miteinander gemischt (5) vorliegen und
  der jeweiligen Strahlung (13 14, 17) wenigstens zeitweise
  ausgesetzt sind.

2. Verfahren nach Anspruch 1, g e k e n n z e i c h n e t
dadurch, daß gleichzeitig mit lichtinduzierter, fotolytischer Abscheidung eine Halbleiterschicht erzeugt und mit wenigstens einem Dotierungsmaterial mit (jeweils) zeitlich
wahlfreiem Dotierungsgrad dotiert wird.

3. Verfahren nach Anspruch 1 oder 2, g e k e n n -
z e i c h n e t   dadurch, daß zwei oder mehr Schichten aufeinanderfolgend ohne zeitliche Unterbrechung der einzelnen
Abscheidungsvorgänge abgeschieden werden.

4. Verfahren nach Anspruch 2, g e k e n n z e i c h n e t
dadurch, daß periodisch abwechselnde Abscheidung der Schichten vorgenommen wird.

5. Verfahren nach Anspruch 3 oder 4, g e k e n n -
z e i c h n e t dadurch, daß die abzuscheidenden Schichten
gleichzeitig mit ihrer Abscheidung zusätzlich noch mit Dotierungsmaterial dotiert werden.

6. Verfahren nach einem der Ansprüche 1 bis 5, g e -
k e n n z e i c h n e t dadurch, daß die gleichzeitige Abscheidung und/oder Dotierung verschiedener Materialien lateral nebeneinander auf der Oberfläche eines Substrats oder
bereits abgeschiedener Schichten durchgeführt wird, wobei
durch Maskierung die verschiedenen lateral nebeneinanderliegenden Abscheidungs- und/oder Dotierungsbereiche mit jeweiliger Strahlung bestrahlt werden.

7. Vorrichtung zur Durchführung eines Verfahrens nach einem
der Ansprüche 1 bis 6, g e k e n n z e i c h n e t dadurch,
daß die optische Vorrichtung so ausgebildet ist, daß die
Strahlungsgänge von wenigstens zwei vorgesehenen Strahlungen
in einem optischen Element derart vereinigt sind, daß diese
Strahlungen mit gleicher Achse auf den Bereich auftreffen,
auf dem die lichtinduzierte, fotolytische Abscheidung und/
oder Dotierung durchzuführen ist.

8. Vorrichtung zur Durchführung eines Verfahrens nach einem
der Ansprüche 1 bis 6, g e k e n n z e i c h n e t dadurch,
daß die für wenigstens zwei voneinander verschiedene Strahlungen vorgesehenen Strahlungsquellen hintereinanderliegend
angeordnet sind, so daß diese Strahlungen mit gleicher Achse
auf den Bereich auftreffen, auf dem die lichtinduzierte,
fotolytische Abscheidung und/oder Dotierung durchzuführen ist.

FIG 1

11

15

13

18

14
15
12

16

17
19

8

4 5 3
2
7 6

FIG 2

36

35

33
31
4

34

32

2

Dot.

136

134

132